# EUROPEAN PATENT SPECIFICATION

(11) **EP 4 528 292 B1**
(45) Date of publication and mention of the grant of the patent: **11.11.2026**
(21) Application number: 24200557.7
(22) Date of filing: 16.09.2024
(51) Int. Cl.: G01R 1/20, G01R 31/28

(54) **INPUT SIGNAL DETECTION CIRCUIT, ELECTRONIC DEVICE, AND SYSTEM**
EINGANGSSIGNALDETEKTIONSSCHALTUNG, ELEKTRONISCHE VORRICHTUNG UND SYSTEM
CIRCUIT DE DÉTECTION DE SIGNAL D'ENTRÉE, DISPOSITIF ÉLECTRONIQUE ET SYSTÈME

(30) Priority: 20.09.2023 JP 2023152199
(43) Date of publication of application: 26.03.2025
(73) Proprietor: Yokogawa Electric Corporation, Tokyo 180-8750 (JP)
(72) Inventor: KUSUNOKI, Shinya, Musashino-shi, Tokyo 180-8750 (JP); IRIE, Koichi, Musashino-shi, Tokyo 180-8750 (JP); HIRATSUKA, Masashi, Musashino-shi, Tokyo 180-8750 (JP); ARIMIZU, Takeshi, Musashino-shi, Tokyo 180-8750 (JP)
(74) Representative: Winter, Brandl - Partnerschaft mbB

(56) References cited:
- US-A1- 2018 365 974

## Description

### FIELD

The present disclosure relates to an input signal detection circuit, an electronic device, and a system.

### BACKGROUND

In a system or an electronic device that controls field instruments or the like that are used in a plant, a factory, or the like, an input signal detection circuit is used for detecting a quantity of state of each of the field instruments on the basis of signals received from the respective field instruments. The quantity of state corresponds to, for example, an electric current. In order to reduce a risk of failure occurrence, such as a failure occurring in a device or the like, an input signal detection circuit constituted in a functional safety device is proposed. In the functional safety device, it is possible to reduce an occurrence risk of a critical fault by applying redundancy to the system by adding, for example, a failure detection circuit that detects a failure of the input signal detection circuit.

As a device used in this way, for example, there is a proposed semiconductor integrated circuit device that includes a target circuit, a first failure detection unit that detects a failure of the target circuit, and a second failure detection unit that detects a failure of the target circuit by using a method that is different from a method used in the first failure detection unit, and that is constituted to satisfy the standards of functional safety (for example, see Japanese Laid-open Patent Publication JP 2023 - 115987 B). Here, the target circuit is a circuit that processes an input signal from an outside of the semiconductor integrated circuit device and that generates an output signal.

### SUMMARY

In the conventional technology described above, the input signal detection circuit and the failure detection circuit (failure detection unit) are arranged in the same integrated circuit (IC). This is to reduce the size of the device. However, in this case, it is not possible to detect a failure of the IC itself, so that redundancy is decreased. In contrast, in order to detect a failure of the IC, the failure detection circuit included in the IC needs to be arranged outside of the IC, and thus, there is a problem in that it is not possible to reduce the size of the device including the input signal detection circuit.
Moreover, US 2018 0365974 A1 discloses a sensor integrated circuit including at least two processing channels responsive to the same or different analog input signals to generate respective processed signals, wherein the two processing channels are non-homogenous. A checker circuit receives the first and second processed signals and is configured to detect a fault in the sensor integrated circuit when the first and second processed signals differ from each other by more than a predetermined amount.

Accordingly, the present disclosure proposes an input signal detection circuit that is reduced in size while maintaining redundancy, and an electronic device and a system that includes the input signal detection circuit.

It is an object of the present invention to at least partially solve the problems in the conventional technology. The invention is set out in the appended set of claims.

According to one aspect of embodiments, An input signal detection circuit comprising: a plurality of input terminals; and a plurality of signal detection units each of which is arranged for each of the plurality of associated input terminals and includes a main signal detection unit that detects a signal received from one of the associated input terminals, and a sub signal detection unit that generates a failure detection signal that is a signal for detecting a failure of the main signal detection unit, wherein the main signal detection unit detects the signal received from the input terminal that is associated with the signal detection unit that includes the associated main signal detection unit, the sub signal detection unit generates the failure detection signal about the main signal detection unit included in the signal detection unit that is different from the signal detection unit that includes the sub signal detection unit, and the sub signal detection unit included in each of the plurality of signal detection units exclusively generates the failure detection signal about the main signal detection unit.

According to one aspect of embodiments, An electronic device comprising: a plurality of input terminals; a plurality of signal detection units each of which is arranged for each of the plurality of associated input terminals and includes a main signal detection unit that detects a signal received from one of the associated input terminals, and a sub signal detection unit that generates a failure detection signal that is a signal for detecting a failure of the main signal detection unit; and
a failure detection unit that detects the failure of the main signal detection unit based on the failure detection signal, wherein the main signal detection unit detects the signal received from the input terminal that is associated with the signal detection unit that includes the associated main signal detection unit, the sub signal detection unit generates the failure detection signal about the main signal detection unit included in the signal detection unit that is different from the signal detection unit that includes the sub signal detection unit, and the sub signal detection unit included in each of the plurality of signal detection units exclusively generates the failure detection signal about the main signal detection unit.

According to one aspect of embodiments, A system comprising: a plurality of input terminals; a plurality of signal detection units each of which is arranged for each of the plurality of associated input terminals and includes a main signal detection unit that detects a signal received from one of the associated input terminals, and a sub signal detection unit that generates a failure detection signal that is a signal for detecting a failure of the main signal detection unit; a failure detection unit that detects the failure of the main signal detection unit based on the failure detection signal; and a failure information output unit that outputs information on the main signal detection unit in which the failure has been detected, wherein the main signal detection unit detects the signal received from the input terminal that is associated with the signal detection unit that includes the associated main signal detection unit, the sub signal detection unit generates the failure detection signal about the main signal detection unit included in the signal detection unit that is different from the signal detection unit that includes the sub signal detection unit, and the sub signal detection unit included in each of the plurality of signal detection units exclusively generates the failure detection signal about the main signal detection unit.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a diagram illustrating a configuration example of a system according to an embodiment of the present disclosure;
FIG. 2 is a diagram illustrating a configuration example of an input signal detection circuit according to a first embodiment of the present disclosure;
FIG. 3 is a diagram illustrating a configuration example of a signal detection unit according to the first embodiment of the present disclosure;
FIG. 4 is a diagram illustrating another configuration example of the input signal detection circuit according to the first embodiment of the present disclosure;
FIG. 5 is a diagram illustrating a configuration example of an input signal detection circuit according to a second embodiment of the present disclosure; and
FIG. 6 is a diagram illustrating a configuration example of an input signal detection circuit according to a third embodiment of the present disclosure.

### DESCRIPTION OF EMBODIMENTS

Preferred embodiments of the present disclosure will be explained in detail below with reference to the accompanying drawings. Descriptions will be made in the following order. In addition, in the embodiments described below, the same components are denoted by the same reference numerals and an overlapping description will be omitted.

### 1. First Embodiment

### Configuration of system

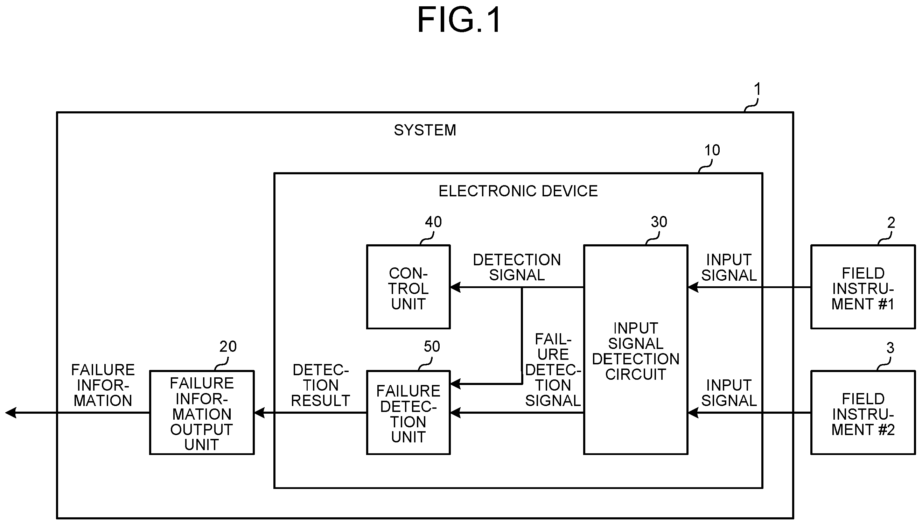

FIG. 1 is a diagram illustrating a configuration example of a system according to an embodiment of the present disclosure. The drawing is a block diagram illustrating a configuration example of a system 1. The system 1 is a system that performs control of a plurality of field instruments. The system 1 detects a state of each of the field instruments on the basis of input signals received from the respective field instruments.

The system 1 includes an electronic device 10 and a failure information output unit 20. Furthermore, in the drawing, a field instrument 2 and a field instrument 3 are illustrated.

The electronic device 10 is a device that detects an input signal received from each of the plurality of field instruments, and performs control of the plurality of field instruments on the basis of the respective detection results. Furthermore, the electronic device 10 further detects a failure of a circuit that detects the input signal, and outputs the detection result to the failure information output unit 20.

The failure information output unit 20 is a unit that generates failure information corresponding to information on the failure of the circuit that detects the input signal included in the electronic device 10 on the basis of the detection result that is output from the electronic device 10. The generated failure information is output to a device that is provided outside of the system 1.

### Configuration of electronic device

The electronic device 10 described above includes an input signal detection circuit 30, a control unit 40, and a failure detection unit 50.

The input signal detection circuit 30 is a circuit that performs detection of the input signal received from each of the field instruments 2 and 3. The input signal detection circuit 30 outputs the detection signal that corresponds to the detection result to the control unit 40 and the failure detection unit 50. Furthermore, the input signal detection circuit 30 generates a failure detection signal for detecting a failure of a circuit (a main signal detection unit 110 that will be described later) that performs detection of the input signal described above, and outputs the generated failure detection signal to the failure detection unit 50.

The control unit 40 is a unit that performs overall control of the electronic device 10. Furthermore, in the case where the control unit 40 controls the field instruments 2 and 3, the control unit 40 is able to output a control signal to each of the field instruments 2 and 3.

The failure detection unit 50 is a unit that detects a failure of the main signal detection unit 110 on the basis of the failure detection signal received from the input signal detection circuit 30. The drawing illustrates an example in which the failure detection unit 50 detects a failure of the main signal detection unit 110 on the basis of the failure detection signal and the detection signal. The detection result of the failure is output to the failure information output unit 20.

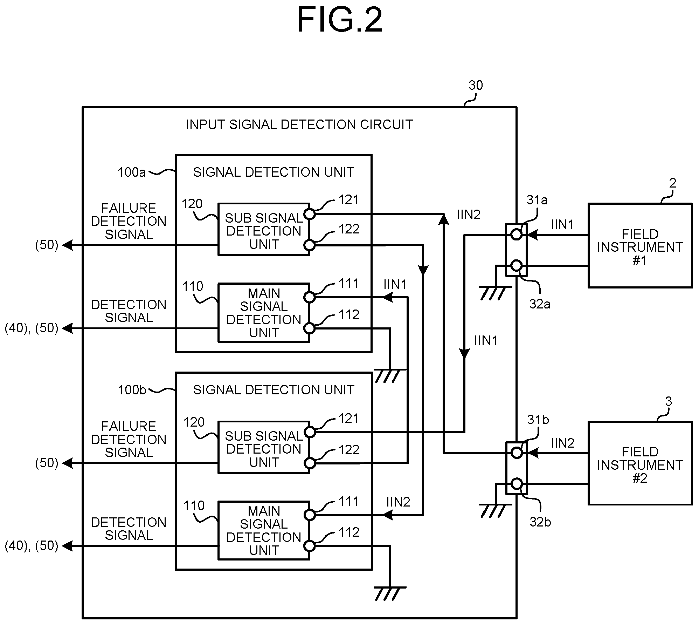

Configuration of input signal detection circuit FIG. 2 is a diagram illustrating a configuration example of the input signal detection circuit according to the first embodiment of the present disclosure. The drawing is a block diagram illustrating the configuration example of the input signal detection circuit 30. The input signal detection circuit 30 includes input terminals 31a and 32a, input terminals 31b and 32b, and signal detection units 100a and 100b. Moreover, the field instruments 2 and 3 illustrated in the drawing output signal electric currents IIN1 and IIN2, respectively.

The input terminals 31a and 32a and the input terminals 31b and 32b are a pair of terminals in each of which a signal received from the field instrument 2 or the like is input. These input terminals are arranged in each of the field instruments. The signal output from the field instrument 2 is input to the input terminals 31a and 32a. Furthermore, the signal output from the field instrument 3 is input to the input terminals 31b and 32b. Moreover, the input terminal 31a and the input terminal 31b correspond to sink side input terminals, whereas the input terminal 32a and the input terminal 32b correspond to source side input terminals.

The signal detection units 100a and 100b are units each of which is arranged for each of the input terminals 31a and 32a and the input terminals 31b and 32b, respectively, and includes the main signal detection unit 110 that detects a signal received from the input terminal 31a or the like. In the input signal detection circuit 30 illustrated in the drawing, the signal detection unit 100a is associated with the input terminals 31a and 32a, whereas the signal detection unit 100b is associated with the input terminals 31b and 32b. A signal detection unit 100 detects an input signal received from the input terminal 31 or the like that is associated with the signal detection unit 100. Furthermore, each of the signal detection units 100a and 100b further includes a sub signal detection unit 120 that generates a failure detection signal that is a signal for detecting a failure of the main signal detection unit 110.

The main signal detection unit 110 is a unit that detects a signal received from the input terminal 31, as described above. The main signal detection unit 110 illustrated in the drawing detects an electric current flowing through the input terminal 31 or the like, and outputs a detection signal that is a detection result. The main signal detection unit 110 includes input terminals 111 and 112. The input terminal 111 corresponds to a sink side input terminal, whereas the input terminal 112 corresponds to a source side input terminal. The main signal detection unit 110 detects an electric current flowing from the input terminal 111 to the input terminal 112. The detection of the electric current is able to be performed by detecting an electric current value. Specifically, a signal according to the electric current value is generated, and the generated signal is able to be output as a detection signal. In this case, the detection signal becomes an analog signal or a digital signal. Furthermore, the main signal detection unit 110 is also able to detect on and off of the electric current, and output the signal binarized in accordance with on and off of the electric current as the detection signal. The main signal detection unit 110 detects an electric current flowing in the input terminal 31 or the like that is associated with the signal detection unit 100 that includes the associated main signal detection unit 110.

The sub signal detection unit 120 is a unit that generates a failure detection signal that is a signal for detecting a failure of the main signal detection unit 110 as described above. The sub signal detection unit 120 illustrated in the drawing detects an electric current flowing into the main signal detection unit 110, and outputs a detection result as a failure detection signal. The sub signal detection unit 120 includes an input terminal 121 and an input terminal 122. The input terminal 121 corresponds to the sink side input terminal, whereas the input terminal 122 corresponds to the source side input terminal. The sub signal detection unit 120 detects an electric current flowing from the input terminal 121 to the input terminal 122.

Furthermore, the sub signal detection unit 120 generates a failure detection signal about the main signal detection unit 110 included in the signal detection unit 100 that is different from the signal detection unit 100 that includes the associated main signal detection unit 110. In the drawing, the sub signal detection unit 120 included in the signal detection unit 100a generates a failure detection signal about the main signal detection unit 110 included in the signal detection unit 100b. Furthermore, the sub signal detection unit 120 included in the signal detection unit 100b generates a failure detection signal about the main signal detection unit 110 included in the signal detection unit 100a.

Moreover, the failure detection unit 50 illustrated in FIG. 1 is able to detect a failure in the case where the detection signal that is output from the main signal detection unit 110 is different from the failure detection signal that is output from the sub signal detection unit 120.

In the following, wiring will be described. The input terminal 32a is grounded, whereas the input terminal 31a is grounded to the input terminal 121 of the sub signal detection unit 120 included in the signal detection unit 100b. The input terminal 122 of the sub signal detection unit 120 included in the signal detection unit 100b is connected to the input terminal 111 of the main signal detection unit 110 included in the signal detection unit 100a. The input terminal 112 of the main signal detection unit 110 included in the signal detection unit 100a is grounded.

The input terminal 32b is grounded, whereas the input terminal 31b is grounded to the input terminal 121 of the sub signal detection unit 120 included in the signal detection unit 100a. The input terminal 122 of the sub signal detection unit 120 included in the signal detection unit 100a is grounded to the input terminal 111 of the main signal detection unit 110 included in the signal detection unit 100b. The input terminal 112 of the main signal detection unit 110 included in the signal detection unit 100b is grounded.

In this way, the sub signal detection unit 120 detects a failure of the main signal detection unit 110 included in the signal detection unit 100 that is different from the signal detection unit 100 that includes the associated sub signal detection unit 120. As a result of this, even in the case where one of the signal detection units 100 is damaged, it is possible to detect a failure of the signal detection unit 100 by the sub signal detection unit 120 included in the other of the signal detection units 100. Furthermore, it is also possible to arrange each of the signal detection unit 100a and the signal detection unit 100b in a different IC. In this case, detection of damage of the IC in which the signal detection unit 100 is arranged is able to be performed by the sub signal detection unit 120. It is possible to ensure redundancy while arranging the main signal detection unit 110 and the sub signal detection unit 120 in the same IC. As a result of this, it is possible to reduce the size of the signal detection unit 100, and it is thus possible to reduce a cost. In addition, the different ICs mentioned here include ICs that are constituted in different semiconductor chips arranged in the same package.

Furthermore, the input signal detection circuit 30 illustrated in the drawing is able to be used as a device having hardware failure tolerance (HFT) of 1 that is specified in IEC 61508 standard.

### Configuration of signal detection unit

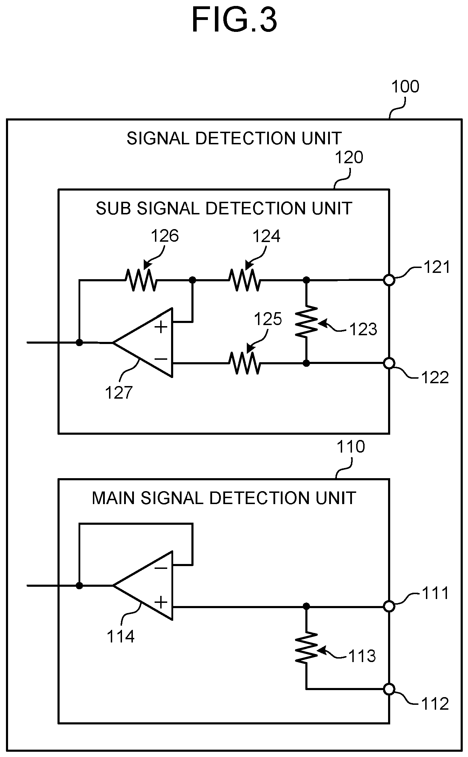

FIG. 3 is a diagram illustrating a configuration example of the signal detection unit according to the first embodiment of the present disclosure. The drawing is a circuit diagram illustrating a configuration example of the signal detection unit 100. The main signal detection unit 110 includes a resistance 113 and an OP amplifier 114. The resistance 113 is connected between the input terminals 111 and 112 and constitutes electric current detection resistance. The OP amplifier 114 is operated as a buffer amplifier.

The sub signal detection unit 120 includes resistance 123 to 126 and an OP amplifier 127. The resistance 123 is connected between the input terminals 121 and 122, and constitutes electric current detection resistance. The circuit including the OP amplifier 127 and the resistance 124 to 126 constitutes a differential amplifier circuit. This differential amplifier circuit amplifies a terminal voltage of the resistance 123 and outputs the amplified terminal voltage.

### Another configuration of input signal detection circuit

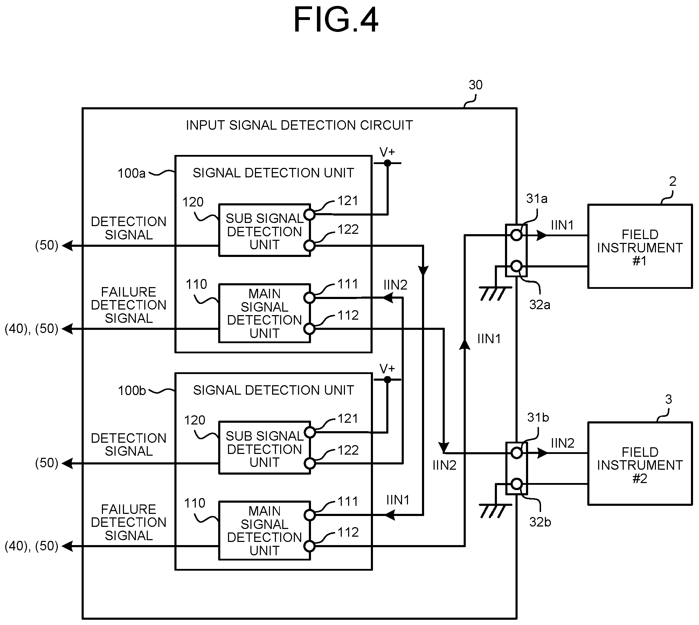

FIG. 4 is a diagram illustrating another configuration example of the input signal detection circuit according to the first embodiment of the present disclosure. The drawing illustrates an example in the case where the electric current received from each of the field instruments 2 and 3 corresponds to a source electric current. An operation of the circuit is the same as that of the input signal detection circuit 30 illustrated in FIG. 3; therefore, descriptions thereof will be omitted.

In this way, the input signal detection circuit 30 according to the first embodiment of the present disclosure is constituted to have a structure in which the main signal detection unit 110 and the sub signal detection unit 120 are arranged in the single signal detection unit 100. As a result of this, it is possible to reduce the number of parts, and it is thus possible to reduce costs. Furthermore, as a result of the number of parts being reduced, it is possible to reduce a failure rate. Furthermore, the two signal detection units 100 each having the main signal detection unit 110 and the sub signal detection unit 120 are arranged, and each of the sub signal detection units 120 included in the associated one of the signal detection units 100 detects a failure of the main signal detection unit 110 included in the other one of the signal detection units 100. As a result of this, even in the case where one of the signal detection units 100 has failed, the sub signal detection unit 120 that is included in the other one of the signal detection units 100 is able to detect a failure, and it is thus possible to satisfy the specifications needed for functional safety.

### 2. Second Embodiment

The two signal detection units 100 are arranged in the input signal detection circuit 30 according to the above described first embodiment. In contrast, the input signal detection circuit 30 according to a second embodiment of the present disclosure is different from the first embodiment described above in that three or more of the input signal detection circuits 30 are arranged.

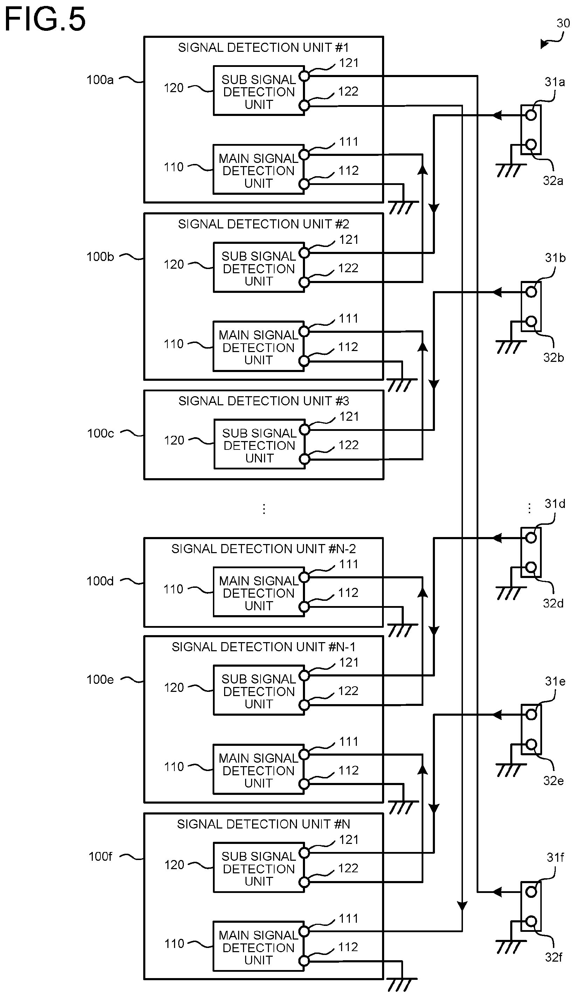

Configuration of input signal detection circuit FIG. 5 is a diagram illustrating a configuration example of an input signal detection circuit according to the second embodiment of the present disclosure. The drawing is a block diagram illustrating a configuration example of the input signal detection circuit 30, similarly to FIG. 2. The input signal detection circuit 30 illustrated in the drawing is different from the input signal detection circuit 30 illustrated in FIG. 2 in that the input signal detection circuit 30 illustrated in the drawing includes N signal detection units 100 (N is an integer of three or more). Furthermore, in the drawing, a part of drawing is omitted in the input signal detection circuit 30.

The input signal detection circuit 30 illustrated in the drawing includes the signal detection unit 100a to a signal detection unit 100f, the input terminals 31a and 32a, the input terminals 31b and 32b, input terminals 31d and 32d, input terminals 31e and 32e, and input terminals 31f and 32f. The input terminal 32a is grounded, whereas the input terminal 31a is connected to the input terminal 121 of the sub signal detection unit 120 included in the signal detection unit (#2) 100b. The input terminal 122 of the sub signal detection unit 120 included in the signal detection unit (#2) 100b is connected to the input terminal 111 of the main signal detection unit 110 included in the signal detection unit (#1) 100a. The input terminal 112 of the main signal detection unit 110 included in the signal detection unit (#1) 100a is grounded. The same wire connection described above is repeated up to the input terminals 31e and 32e and the signal detection unit 100e.

The input terminal 32f is grounded, whereas the input terminal 31f is connected to the input terminal 121 of the sub signal detection unit 120 included in the signal detection unit (#1) 100a. The input terminal 122 of the sub signal detection unit 120 included in the signal detection unit (#1) 100a is connected to the input terminal 111 of the included in the signal detection unit (#N) 100f. The input terminal 112 of the main signal detection unit 110 included in the signal detection unit (#N) 100f is grounded.

In this way, even in the case where three or more of the signal detection units 100 are used, it is possible to constitute the input signal detection circuit 30. Furthermore, each of the plurality of sub signal detection units 120 exclusively generates a failure detection signal about the associated main signal detection unit 110. Here, exclusive mentioned here means an exclusion of a case in which each of the plurality of sub signal detection units 120 generates a failure detection signal about the same main signal detection unit 110. In this case, only the one of the sub signal detection units 120 generates a failure detection signal about the single main signal detection unit 110. Furthermore, in the case where the number of the signal detection unit 100 indicates even number, it is possible to use a method of repeatedly constituting the configuration of the input signal detection circuit 30 illustrated in FIG. 2.

The configuration of the input signal detection circuit 30 other than this is the same as the configuration of the input signal detection circuit 30 according to the first embodiment of the present disclosure; therefore, descriptions thereof will be omitted.

### 3. Third Embodiment

The input signal detection circuit 30 according to the first embodiment described above is constituted such that the sub signal detection unit 120 detects an electric current. In contrast, the input signal detection circuit 30 according to a third embodiment of the present disclosure is different from the input signal detection circuit 30 according to the first embodiment described above in that the input signal detection circuit 30 according to the third embodiment is constituted such that the sub signal detection unit detects a voltage of the main signal detection unit 110.

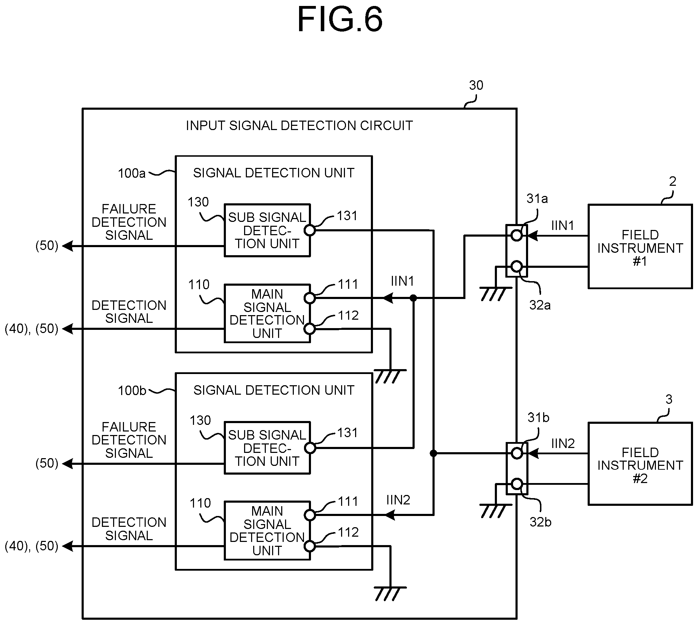

Configuration of input signal detection circuit FIG. 6 is a diagram illustrating a configuration example of the input signal detection circuit according to the third embodiment of the present disclosure. The drawing is a block diagram illustrating a configuration example of the input signal detection circuit 30, similarly to FIG. 2. The input signal detection circuit 30 illustrated in the drawing is different from the input signal detection circuit 30 illustrated in FIG. 2 in that the input signal detection circuit 30 illustrated in the drawing includes a sub signal detection unit 130 instead of the sub signal detection unit 120.

The sub signal detection unit 130 generates a failure detection signal on the basis of the voltage of the input terminal of the main signal detection unit 110. The sub signal detection unit 130 includes an input terminal 131. The input terminal 131 is connected to the input terminal 111 included in the main signal detection unit 110. In this case, the failure detection unit 50 illustrated in FIG. 1 is able to determine that a failure occurs when, for example, a failure detection signal indicates a value of "0".

The other configuration of the input signal detection circuit 30 is the same as that of the input signal detection circuit 30 according to the first embodiment of the present disclosure; therefore, descriptions thereof will be omitted.

Furthermore, the effect described in this application is only an example and is not limited to this. Another effect may be provided.

Although the invention has been described with respect to specific embodiments for a complete and clear disclosure, the appended claims are not to be thus limited but are to be construed as embodying all modifications and alternative constructions that may occur to one skilled in the art that fall within the scope of the invention as defined by the claims.

## Claims

1. An input signal detection circuit (30) comprising:
a plurality of input terminals (31a, 31b, 31d, 31e, 31f); and
a plurality of signal detection units (100a, 100b) each of which is arranged for each of the plurality of associated input terminals (31a, 31b, 31d, 31e, 31f) and includes
a main signal detection unit (110) that detects a signal received from one of the associated input terminals (31a, 31b, 31d, 31e, 31f), and
a sub signal detection unit (120) that generates a failure detection signal that is a signal for detecting a failure of the main signal detection unit (110), wherein
the main signal detection unit (110) detects the signal received from the input terminal (31a, 31b, 31d, 31e, 31f) that is associated with the signal detection unit (100a, 100b) that includes the associated main signal detection unit (110),
**characterized in that**
the sub signal detection unit (120) generates the failure detection signal about the main signal detection unit (110) included in the signal detection unit (100a, 100b) that is different from the signal detection unit (100a, 100b) that includes the sub signal detection unit (120), and
the sub signal detection unit (120) included in each of the plurality of signal detection units (100a, 100b) exclusively generates the failure detection signal about the main signal detection unit (110).

2. The input signal detection circuit (30) according to claim 1, wherein each of the plurality of signal detection units (100a, 100b) is arranged in a different integrated circuit.

3. The input signal detection circuit (30) according to claim 1 or 2, wherein the main signal detection unit (110) detects an electric current flowing through the input terminals (31a, 31b, 31d, 31e, 31f) as the signal.

4. The input signal detection circuit (30) according to claim 3, wherein the sub signal detection unit (120) generates the failure detection signal based on the electric current flowing through the input terminals (31a, 31b, 31d, 31e, 31f) associated with the main signal detection unit (110) whose failure is detected by the sub signal detection unit (120).

5. The input signal detection circuit (30) according to claim 3, wherein the sub signal detection unit (120) generates the failure detection signal based on a voltage of the main signal detection unit (110) whose failure is detected by the sub signal detection unit (120).

6. An electronic device (10) comprising:
the input signal detection circuit (30) according to any of claims 1 to 5;
a control unit (40); and
a failure detection unit (50) that detects the failure of the main signal detection unit (110) based on the failure detection signal.

7. A system (1) comprising:
the electronic device (10) according to claim 6; and
a failure information output unit (20) that outputs information on the main signal detection unit (110) in which the failure has been detected.

## Patentansprüche

1. Eingabesignal-Detektionsschaltung (30), die aufweist:
eine Vielzahl von Eingabeanschlüssen (31a, 31b, 31d, 31e, 31f); und
eine Vielzahl von Signaldetektionseinheiten (100a, 100b), von denen jede für jeden der Vielzahl von zugeordneten Eingabeanschlüssen (31a, 31b, 31d, 31e, 31f) angeordnet ist und enthält:
eine Hauptsignal-Detektionseinheit (110), die ein Signal detektiert, das von einem der zugeordneten Eingabeanschlüsse (31a, 31b, 31d, 31e, 31f) empfangen wird, und
eine Untersignal-Detektionseinheit (120), die ein Ausfalldetektionssignal erzeugt, das ein Signal zum Detektieren eines Ausfalls der Hauptsignal-Detektionseinheit (110) ist, wobei
die Hauptsignal-Detektionseinheit (110) das Signal detektiert, das von dem Eingabeanschluss (31a, 31b, 31d, 31e, 31f) empfangen wird, der der Signaldetektionseinheit (100a, 100b), die die zugeordnete Hauptsignal-Detektionseinheit (110) enthält, zugeordnet ist,
**dadurch gekennzeichnet, dass**
die Untersignal-Detektionseinheit (120) das Ausfalldetektionssignal über die Hauptsignal-Detektionseinheit (110) erzeugt, die in der Signaldetektionseinheit (100a, 100b) enthalten ist, die sich von der Signaldetektionseinheit (100a, 100b), die die Untersignal-Detektionseinheit (120) enthält, unterscheidet, und
die Untersignal-Detektionseinheit (120), die in jeder der Vielzahl von Signaldetektionseinheiten (100a, 100b) enthalten ist, ausschließlich das Ausfalldetektionssignal über die Hauptsignal-Detektionseinheit (110) erzeugt.

2. Eingabesignal-Detektionsschaltung (30) nach Anspruch 1, wobei jede der Vielzahl von Signaldetektionseinheiten (100a, 100b) in einer unterschiedlichen integrierten Schaltung angeordnet ist.

3. Eingabesignal-Detektionsschaltung (30) nach Anspruch 1 oder 2, wobei die Hauptsignal-Detektionseinheit (110) einen elektrischen Strom, der durch die Eingabeanschlüsse (31a, 31b, 31d, 31e, 31f) fließt, als das Signal detektiert.

4. Eingabesignal-Detektionsschaltung (30) nach Anspruch 3, wobei die Untersignal-Detektionseinheit (120) das Ausfalldetektionssignal basierend auf dem elektrischen Strom erzeugt, der durch die Eingabeanschlüsse (31a, 31b, 31d, 31e, 31f) fließt, die der Hauptsignal-Detektionseinheit (110), deren Ausfall durch die Untersignal-Detektionseinheit (120) detektiert wird, zugeordnet sind.

5. Eingabesignal-Detektionsschaltung (30) nach Anspruch 3, wobei die Untersignal-Detektionseinheit (120) das Ausfalldetektionssignal basierend auf einer Spannung der Hauptsignal-Detektionseinheit (110), deren Ausfall durch die Untersignal-Detektionseinheit (120) detektiert wird, erzeugt.

6. Elektronische Vorrichtung (10), die aufweist:
die Eingabesignal-Detektionsschaltung (30) nach einem der Ansprüche 1 bis 5;
eine Steuerungseinheit (40); und
eine Ausfalldetektionseinheit (50), die den Ausfall der Hauptsignal-Detektionseinheit (110) basierend auf dem Ausfalldetektionssignal detektiert.

7. System (1), das aufweist:
die elektronische Vorrichtung (10) nach Anspruch 6; und
eine Ausfallinformations-Ausgabeeinheit (20), die Informationen über die Hauptsignal-Detektionseinheit (110), in der der Ausfall detektiert worden ist, ausgibt.

## Revendications

1. Circuit de détection de signal d'entrée (30) comprenant :
une pluralité de bornes d'entrée (31a, 31b, 31d, 31e, 31f) ; et
une pluralité d'unités de détection de signal (100a, 100b), chacune étant agencée pour chacune de la pluralité de bornes d'entrée associées (31a, 31b, 31d, 31e, 31f), et inclut
une unité de détection de signal principale (110) qui détecte un signal reçu d'une des bornes d'entrée associées (31a, 31b, 31d, 31e, 31f), et
une unité de détection de sous-signal (120) qui génère un signal de détection de défaillance qui est un signal destiné à détecter une défaillance de l'unité de détection de signal principale (110), dans lequel l'unité de détection de signal principale (110) détecte le signal reçu de la borne d'entrée (31a, 31b, 31d, 31e, 31f) qui est associée à l'unité de détection de signal (100a, 100b) qui inclut l'unité de détection de signal principale associée (110),
**caractérisé en ce que**
l'unité de détection de sous-signal (120) génère le signal de détection de défaillance concernant l'unité de détection de signal principale (110) incluse dans l'unité de détection de signal (100a, 100b) qui est différente de l'unité de détection de signal (100a, 100b) qui inclut l'unité de détection de sous-signal (120), et
l'unité de détection de sous-signal (120) incluse dans chacune de la pluralité d'unités de détection de signal (100a, 100b) génère exclusivement le signal de détection de défaillance concernant l'unité de détection de signal principale (110).

2. Circuit de détection de signal d'entrée (30) selon la revendication 1, dans lequel chacune de la pluralité d'unités de détection de signal (100a, 100b) est agencée dans un circuit intégré différent.

3. Circuit de détection de signal d'entrée (30) selon la revendication 1 ou 2, dans lequel l'unité de détection de signal principale (110) détecte un courant électrique circulant à travers les bornes d'entrée (31a, 31b, 31d, 31e, 31f) comme signal.

4. Circuit de détection de signal d'entrée (30) selon la revendication 3, dans lequel l'unité de détection de sous-signal (120) génère le signal de détection de défaillance sur la base du courant électrique circulant à travers les bornes d'entrée (31a, 31b, 31d, 31e, 31f) associées à l'unité de détection de signal principale (110) dont la défaillance est détectée par l'unité de détection de sous-signal (120).

5. Circuit de détection de signal d'entrée (30) selon la revendication 3, dans lequel l'unité de détection de sous-signal (120) génère le signal de détection de défaillance sur la base d'une tension de l'unité de détection de signal principale (110) dont la défaillance est détectée par l'unité de détection de sous-signal (120).

6. Dispositif électronique (10) comprenant :
le circuit de détection de signal d'entrée (30) selon l'une quelconque des revendications 1 à 5 ;
une unité de commande (40) ; et
une unité de détection de défaillance (50) qui détecte la défaillance de l'unité de détection de signal principale (110) sur la base du signal de détection de défaillance.

7. Système (1) comprenant :
le dispositif électronique (10) selon la revendication 6 ; et
une unité d'émission d'informations de défaillance (20) qui émet des informations sur l'unité de détection de signal principale (110) dans laquelle la défaillance a été détectée.
